Europäisches Patentamt

European Patent Office

Office européen des brevets

(19)

(11) **EP 1 134 895 A2**

(12) **EUROPÄISCHE PATENTANMELDUNG**

(43) Veröffentlichungstag:
**19.09.2001 Patentblatt 2001/38**

(51) Int Cl.⁷: **H03K 17/96, E03C 1/05**

(21) Anmeldenummer: **01103415.4**

(22) Anmeldetag: **14.02.2001**

(84) Benannte Vertragsstaaten:
**AT BE CH CY DE DK ES FI FR GB GR IE IT LI LU MC NL PT SE TR**
Benannte Erstreckungsstaaten:
**AL LT LV MK RO SI**

(30) Priorität: **08.03.2000 DE 10011229**

(71) Anmelder: **Friedrich Grohe AG & Co. KG**
**58653 Hemer (DE)**

(72) Erfinder: **Rudrich, Hans-Peter, Dipl.-Ing.**
**81373 München (DE)**

(74) Vertreter: **Pätzold, Herbert, Dr.**
**Pätzold, Tandler, Riegger & Kollegen,**
**Steubstrasse 10**
**82116 Gräfelfing (DE)**

(54) **Berührungssensor, Sanitärarmatur mit Berührungssensor und Verfahren zur Erkennung einer Berührung einer elektrisch leitfähigen Oberfläche**

(57)   Berührungssensor mit einer gegenüber Erdpotential isolierten Sensorfläche, wobei die Sensorfläche über einen Meßwiderstand mit einem Wechselspannungsgenerator verbunden ist, und wobei die an dem Meßwiderstand anliegende Spannung als Differenzmeßsignal dient.

Wenigstens ein Berührungssensor kann vorteilhaft in eine Sanitärarmatur integriert sein und zur Steuerung von Magnetventilen an Wasserzuläufen der Armatur dienen.

Ein Bedienelement der Armatur dient als Sensorfläche und ist über ein Anschlußkabel mit einer Steuerungselektronik des Sensors verbunden.

Verfahren zur Erkennung der Berührung einer elektrisch leitenden Oberfläche, wobei ein kapazitiver Berührungssensor verwendet wird, der den komplexen Leitwert eines menschlichen Körpers detektiert.

Die Berührungserkennung erfolgt durch Messung und Auswertung eines Stromflusses in Richtung aus dem Sensor zur Person, die die Sensorfläche berührt und/oder in Richtung von der Person in den Sensor.

Fig.5

EP 1 134 895 A2

**Beschreibung**

Moderne elektronisch gesteuerte Geräte weisen sogenannte kapazitive Sensoren auf, die es ermöglichen, über eine Nahannäherung oder Berührung einer Sensorfläche mit der Hand das Gerät zu steuern. Beispielsweise sind berührungssensitive Monitore bekannt, deren Berührung an geeigneter Position den Ablauf eines auf dem Monitor dargestellten Computerprogrammes steuert.

Beispielsweise basieren außerdem moderne elektrisch bzw. elektronisch gesteuerte sanitäre Armaturen auf hochentwickelten umfangreichen elektronischen Schaltungsanordnungen (Mikroprozessoren/Mikrocontroller), die entweder von einer Batterie oder über einen Netzspannungswandler mit Energieversorgt werden. Eine derartige Steuerung von Sanitärarmaturen verfügt meist über einen elektrischen Signalgeber, im einfachsten Fall über einen mechanischen Schalter, dessen Betätigung die elektronische Steuerung veranlaßt, die vom Anwender gewünschte Funktion der Armatur auszulösen. Beispielsweise sei hier die Betätigung eines Piezotasters in einer elektronischen Duschsteuerung genannt, mit dessen Betätigung der Anwender den Wasserfluß steuern, d. h. starten oder gegebenenfalls auch stoppen kann. Außerdem sind bei Sanitärarmaturen als Signalgeber für elektronische Schaltungsanordnungen Infrarotreflexlichtschranken weit verbreitet, die bei Erfassung eines Gegenstandes, Körpers, Körperteiles etc. im Detektionsbereich einer Mikroprozessorsteuerung ein entsprechendes elektrisches Signal übermittelt. Es sind auch elektronisch gesteuerte Armaturausführungen bekannt, die neben einem ersten Signalgeber für die Basisfunktion der Armatur einen weiteren Signalgeber zur Aktivierung und Deaktivierung von Sonderfunktionen oder zur Änderung von Betriebsparametern aufweisen. Beispielsweise wird in der DE-195 08 644 die Funktionsweise einer Steuerung mit einem in der Armatur integrierten und von außen zugänglichen Tastschalter beschrieben.

Mechanische Signalgeber zur Steuerung von insbesondere elektronischen Armaturen sind jedoch aufgrund ihrer geringen mechanischen Festigkeit leicht von außerhalb der Armatur zu zerstören und daher anfällig gegenüber Vandalismus. Außerdem sind die mechanischen Signalgeber aufgrund von Kontaktabnutzung relativ verschleißfreudig und weisen daher eine nur begrenzte Lebensdauer auf. Bei ihrem Einsatz in elektronischen Sanitärarmaturen ist es auch nötig, die mechanischen Schalter vor Feuchtigkeit zu schützen, wofür aufwendige Isolations- und Abdichtungsmaßnahmen erforderlich sind, was die Herstellung einer derartigen Armatur kompliziert und dementsprechend teuer macht.

Aufgrund der vorstehenden Nachteile der mechanisch betätigbaren Signalgeber (Schalter, Taster) zur Steuerung von insbesondere Sanitärarmaturen wurde daher versucht, die mechanisch betätigbaren Signalgeber durch kapazitive Sensoren zu ersetzen, die, wie oben gesagt, eine Funktionssteuerung über Nahannäherung oder Berührung ermöglichen. Hier sei beispielsweise auf die US 7,730,165 verwiesen, bei der die Wasserabgabe einer Armatur über einen kapazitiven Sensor gesteuert wird, der die Annäherung eines Anwenders an die Armatur detektiert.

Derartige herkömmliche kapazitive Sensoren erfordern jedoch eine äußerst komplexe Signalverarbeitungselektronik, was mit entsprechend hohen Kosten und großem Bauvolumen verbunden ist. Außerdem sind derartige kapazitive Sensoren sehr störanfällig gegenüber elektrostatischen Entladungen, elektromagnetischer Einstrahlung und äußerst empfindlich gegenüber Änderungen der Dielektrizitätskonstanten im umgebenden Medien, z. B. durch Feuchtigkeit, Benetzung, Wasserdampf, uva., weshalb sie insbesondere im Sanitärarmaturenbereich auch bei Vorsehung einer entsprechend komplexen Steuerungselektronik nur bedingt einsetzbar sind. Außerdem benötigen die vorstehenden herkömmlichen kapazitiven Berührungssensoren eine niederohmige, unmittelbare Verbindung des Armaturenbasiskörpers mit dem Schutzleiterpotential, was die Installation derartiger Armaturen ebenfalls verkompliziert und verteuert.

Es ist daher Aufgabe der vorliegenden Erfindung, einen möglichst einfach aufgebauten zuverlässigen Berührungssensor bereitzustellen, der auch im Sanitärarmaturenbereich problemlos und kostengünstig einsetzbar ist.

Die Aufgabe der vorliegenden Erfindung wird mit den Merkmalen der unabhängigen Ansprüche gelöst. Vorteilhafte Ausführungen der Erfindung sind in den Unteransprüchen und/oder der nachfolgenden Beschreibung erwähnt, die von schematischen Zeichnungen begleitet ist. Hierzu zeigt:

| Fig. 1 und 2 | das Funktionsprinzip eines erfindungsgemäßen kapazitiven Berührungssensors; |
| Fig. 3 | ein erstes Schaltbild eines erfindungsgemäßen kapazitiven Berührungssensor; |
| Fig. 4 | ein zweites Schaltbild eines erfindungsgemäßen kapazitiven Berührungssensors; |
| Fig. 5 | einen erfindungsgemäßen Berührungssensor, der in einer erfindungsgemäßen Sanitärarmatur angeordnet ist. |

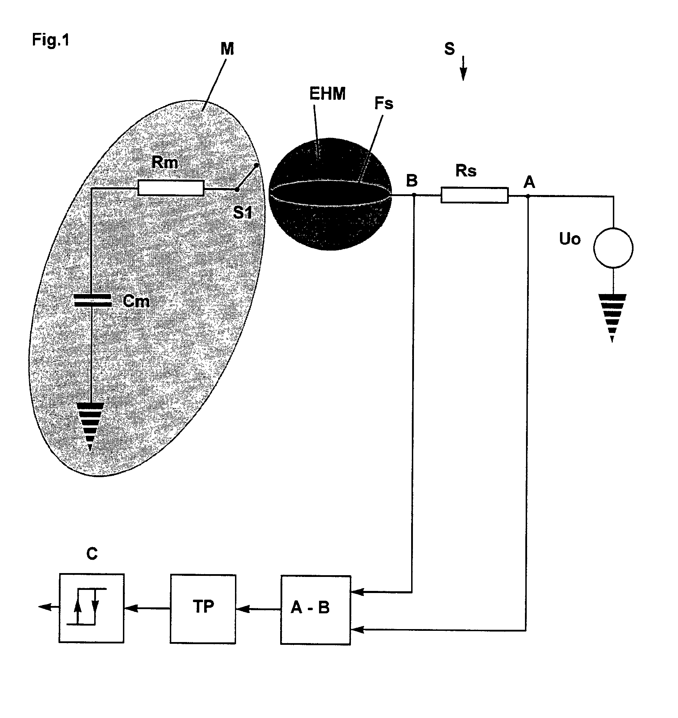

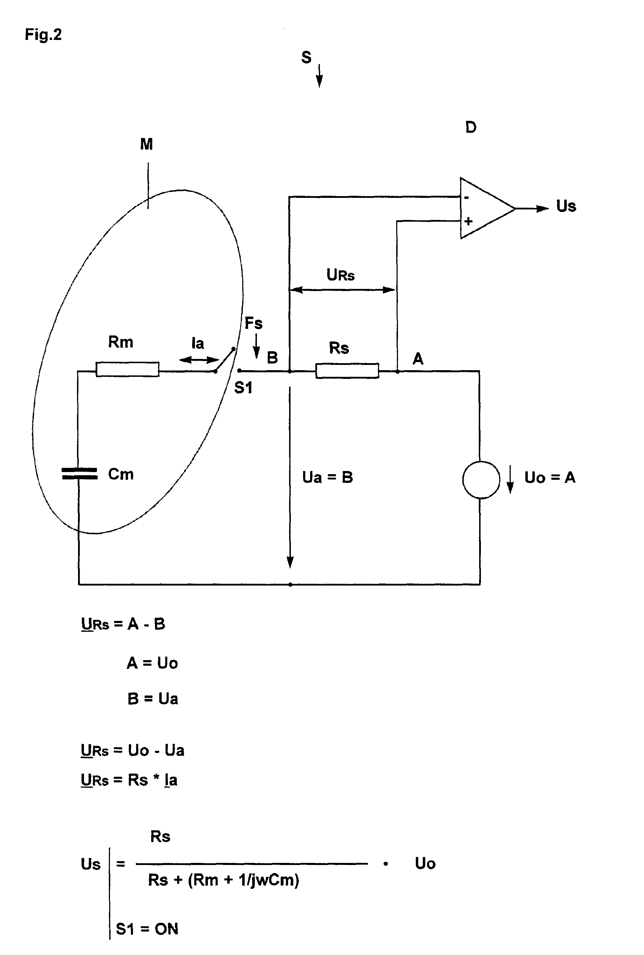

Fig. 1 und 2 zeigen eine schematische Darstellung des prinzipiellen Aufbaus eines erfindungsgemäßen Berührungssensors S zusammen mit einem vereinfachten elektrotechnischen Analogon eines Menschens M. Erfindungsgemäß besteht der Berührungssensor S aus einer gegenüber dem Erdpotential isolierten leitfähigen Sensorfläche Fs, die über einen Meßwiderstand Rs mit einem Wechselspannungsgenerator Uo verbunden ist, wobei die Phasenverschiebung der an dem Meßwiderstand Rs anliegenden Spannung als Meßsignal verwendet wird. Die an dem Meßwiderstand Rs anliegende Spannung wird von einer geeigneten Signalverarbeitungselektronik, bestehend aus Differenzverstärker A-B, Integrator (Filter) TP und Komparator C ausgewertet. Fig. 1 und 2 zeigen außerdem das vereinfachte elektrotechnische Ersatzschaltbild ZM eines menschlichen Körpers M, das prinzipiell mittels eines seriell geschalteten RC-Glieds, Rm, Cm dessen Kondensator Cm an Erdpotential liegt, dargestellt werden kann. Ebenso kann die Berührung des Menschen M mit der Sensorfläche Fs in dem Schaltbild mit dem Schalter S1 dargestellt werden, wobei der Widerstand Rm bei geschlossenem Schalter S1 elektrisch mit der Sensorfläche Fs und dem Widerstand Rs verbunden ist, und bei geöffnetem Schalter S1 elektrisch von der Sensorfläche Fs unterbrochen ist. Das in Fig. 1 und 2 dargestellte Funktionsprinzip des erfindungsgemäßen Berührungssensors S kann mit den nachstehenden Gleichungen beschrieben werden.

| | |
|---|---|
| Rs: | Meßwiderstand |
| Rm: | Widerstand (Mensch) } Ersatzwiderstand: ZM |
| Cm: | Kondensator (Mensch) } komplex |
| Uo: | Wechselspannung |
| Us: | Signalspannung |
| Ia: | Stromfluß von Rm nach Rs oder umgekehrt (komplex) |
| $\omega$: | Frequenz der Wechselspannung |
| M: | Mensch (komplexes Ersatzschaltbild) |
| D: | Differenzverstärker (Subtrahierglied) |

$$ZM = Rm + Cm$$

$$\underline{M} = Rm + 1/i\omega\, Cm\, ;$$

$$\underline{Us} = Uo - [Uo - Rs * \underline{Ia}]\, ;$$

$$\underline{Us} = Rs * \underline{Ia}\, ;$$

$$\underline{Ia} = \frac{Uo}{Rs + (Rm + 1/i\omega\, Cm)}\, ;$$

$$\Rightarrow$$

$$\underline{Us} = Uo - Uo\, (Rs + \underline{M})\, ;$$

1.)

$$\underline{Us} = \frac{Rs * Uo}{Rs + (Rm + 1/i\,\omega\, Cm)}\, ; \qquad \text{für S1 = geschlossen}$$

2.) $\underline{Us} = \phi\, ; \qquad$ für S1 = offen

Erfindungsgemäß wird mit dem Berührungssensor S das Vorhandensein des komplexen Leitwerts eines menschlichen Körpers und/oder eine ggf. überlagerte Wechselstromeinprägung (Störsignaleinprägung z. B. Brummspannung) erkannt. Dabei erfolgt die Berührungerkennung durch die Messung und Auswertung des Stromflusses la in Richtung aus dem Sensor zum Anwender und/oder in Richtung vom Anwender in den Sensor. Erfindungsgemäß basiert der Berührungssensor S daher auf einem dualen, bidirektionalen Verfahren, dessen Vorteile gegenüber den herkömmlichen Verfahren nachfolgend beschrieben werden.

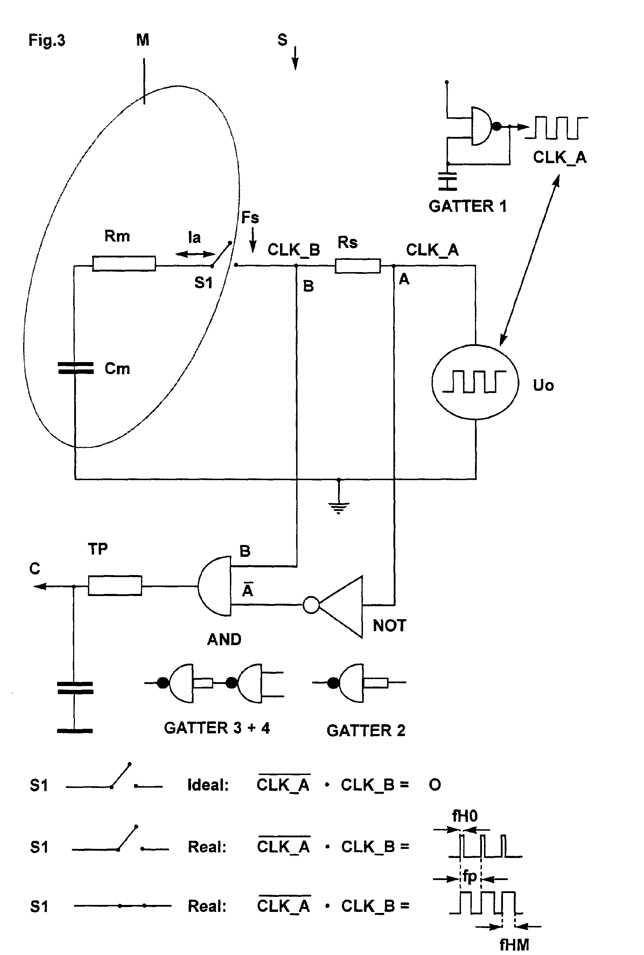

Fig. 3 zeigt ein Schaltbild eines erfindungsgemäßen Berührungssensors S. Ein geerdeter Wechselspannungsgenerator mit niedriger Spannungsamplitude Uo ist über einen Meßwiderstand Rs mit einer Sensorfläche Fs verbunden, die zu dem Erdpotential auch keine niederohmige galvanische Verbindung aufweist. Der Wechselspannungsgenerator Uo ist geeigneterweise mittels einem ersten Gatter GATTER 1, bereitgestellt, das derart aufgebaut ist, dass eine Rechteckwechselspannung mit einer Frequenz im Bereich von 100 kHz erzeugt wird. Erfindungsgemäß wird die an dem Meßwiderstand Rs anliegende Spannung an den Punkten A und B wie folgt abgegriffen. Ein erster Eingang $\bar{A}$, einer AND-Schaltung ist über eine NOT-Schaltung mit dem Punkt A des Meßwiderstands Rs verbunden, und ein zweiter Eingang B, der AND-Schaltung ist sensorflächenseitig (Punkt B) mit dem Meßwiderstand Rs verbunden. Der AND-Schaltung ist ein Integrator TP nachgeschaltet, und dem Integrator TP ist beispielsweise ein Komparator C und/oder ein Mikrocontroller C, zur Herausfilterung von Drift, nachgeschaltet. Dabei wird die NOT-Schaltung von einem zweiten Gatter, GATTER 2, und die AND-Schaltung von einem dritten Gatter, GATTER 3 und einem vierten Gatter, GATTER 4 bereitgestellt. Die AND-Schaltung und die NOT-Schaltung wirken zusammen als das in Fig. 2 schematisch dargestellte Differenzelement D. Die NOT-Schaltung kehrt das Vorzeichen der Spannung CLK_A um und gibt die Spannung CLK_A aus, und die AND-Schaltung summiert die Spannung ihrer beiden Eingänge CLK_A und CLK_B, und das Ergebnis wird an den Integrator TP und zur Analyse an den Komparator C und/oder nachgeschalteten Mikrocontroller C weitergegeben. Bei geöffnetem Schalter S1 ist bei idealer Betrachtungsweise die Phasenverschiebung der Spannung CLK_B und CLK_A gleich 0. In der Realität tritt jedoch auch bei geöffnetem Schalter S1 eine geringe Phasenverschiebung fH0 von CLK_A und CLK_B auf. fH0 in Fig. 3 repräsentiert das Nullsignal des erfindungsgemäßen Sensors S. Bei geschlossenem Schalter S1, d. h. bei Berührung eines Menschen M mit der Fläche Fs, fließt ein Strom la von dem Meßwiderstand Rs in Richtung zu dem menschlichen Widerstand Rm und/oder von dem menschlichen Widerstand Rm zu dem Meßwiderstand Rs und erzeugt eine gegenüber der Null-Phasenverschiebung vergrößerte Phasenverschiebung fHM. fHM repräsentiert das Ausgangssignal des erfindungsgemäßen Sensors, bei Berührung der Fläche Fs durch einen Menschen M.

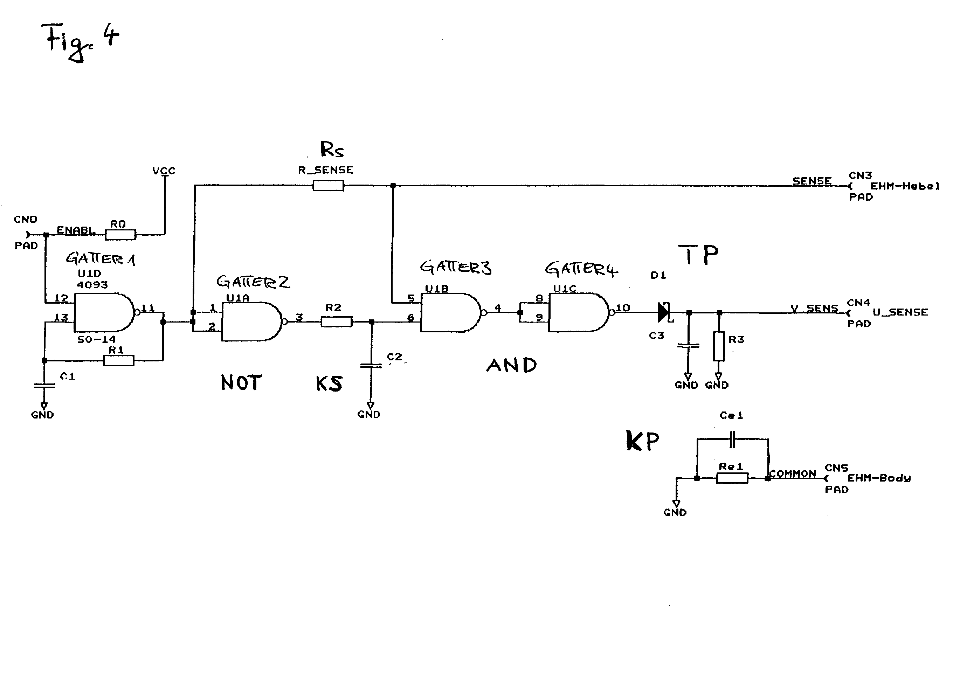

Fig. 4 zeigt eine detaillierte Ausführung des erfindungsgemäßen Berührungssensors S, welcher über einen mittels Diode D1 und Kondensator C3 und Widerstand R3 aufgebauten Integrator TP verfügt. Damit werden das Null- und Meßsignal fH0 und fHM aus Fig. 3 in entsprechende Gleichspannungsamplituden umgesetzt. Die Ausgangsspannung Us kann nun beispielsweise in einem nachfolgenden Komparator C und/oder einem nachgeschalteten Mikrokontroller C ausgewertet werden. Außerdem verfügt der in dem Schaltbild von Fig. 4 dargestellte Berührungssensor S über ein aus dem Widerstand R2 und dem Kondensator C2 bestehendes Kompensationsglied KS zur Nulleinstellung, das zwischen das zweite Gatter GATTER 2 des NOT - Glieds und das dritte Gatter GATTER3 des AND-Glieds geschaltet ist.

Der vorstehend anhand der Figuren Fig. 1 bis 4 beschriebene erfindungsgemäße Berührungssensor S hat gegenüber bekannten kapazitiven Berührungssensoren die folgenden Vorteile. Der erfindungsgemäße Berührungssensor S ist einfachst aufgebaut, wobei das eigentliche Sensorelement lediglich aus einem ohmschen Widerstand Rs besteht. Außerdem ist die Signalauswerteelektronik mit minimalem Bauteilaufwand ausschließlich unter Verwendung von Low-cost-Bauteilen realisierbar und daher einfach, raum- und zeitsparend und kostengünstig herstellbar. Der elektrische Anschluß der Sensorfläche Fs an die Steuerelektronik erfolgt außerdem anders als bei herkömmlichen kapazitiven Berührungssensoren über einen einzigen Leiter, der nicht abgeschirmt zu werden braucht. Es ist daher möglich, mit dem erfindungsgemäßen Berührungssensor S auf abgeschirmte Koax-Leitungen zum Anschluß der Sensorfläche an die Auswerteelektronik, die bei bislang bekannten kapazitiven Sensoren erforderlich sind, zu verzichten. Da die Sensorfläche außerdem niederohmig (typischerweise 10 - 20 kΩ) an die Signalverarbeitungselektronik angekoppelt ist, ist der Berührungssensor S sehr störsicher und unempfindlich gegenüber äußeren parasitären komplexen Leitwerten, die z. B. aufgrund von Verschmutzungen der Sensorfläche Fs bei herkömmlichen kapazitiven Sensoren auftreten. Aufgrund der relativ niederohmigen Signalanbindung kann der Berührungssensor S gegenüber elektromagnetischen Störfeldern unempfindlich ausgebildet werden. Die Funktionsfähigkeit ist nahezu unabhängig von der Gestalt und Form sowie der Größe der Sensorfläche Fs, da der Berührungssensor S nahezu unabhängig von der Oberflächenkapazität der Berührungsfläche Fs zur Umgebung ist, ebenso wie die Funktionsfähigkeit des Berührungssensors S unempfindlich gegenüber Änderungen der Dielektrizitätskonstanten der Umgebung ist. Die zu berührende Sensorfläche Fs kann daher nahezu beliebig ausgebildet sein und muß vom Anwender zur Auslösung eines Sensorsignals tatsächlich berührt werden. Voneinander isolierte Teilflächen der Berührungsfläche Fs für selektierbare, unterschiedliche Funktionen sind ebenfalls problemlos möglich. Der Sensor ist außerdem absolut verschleißfrei, wobei seine Lebensdauer nur durch die Zuverlässigkeit der Signalelektronik bestimmt ist, so daß die Angabe einer minimalen Schaltzyklenanzahl, wie sie bei Kontaktschaltern erforderlich ist, entfällt.

Aufgrund der vorstehend beschriebenen Vorteile gegenüber herkömmlichen kapazitiven Berührungssensoren, insbesondere aufgrund der Unempfindlichkeit gegenüber Änderungen der Dielektrizitätskonstante der Umgebung und der Störsicherheit und Unempfindlichkeit gegenüber äußeren parasitären komplexen Leitwerten, der elektromagnetischen Verträglichkeit, und des Anschlusses der Sensorfläche Fs an die Steuerelektronik über einen einzigen nicht abgeschirmten Leiter ist der erfindungsgemäße Berührungssensor S besonders geeignet, zur Steuerung von modernen elektrisch bzw. elektronisch gesteuerten Sanitärarmaturen eingesetzt und in derartige Sanitärarmaturen integriert zu werden.

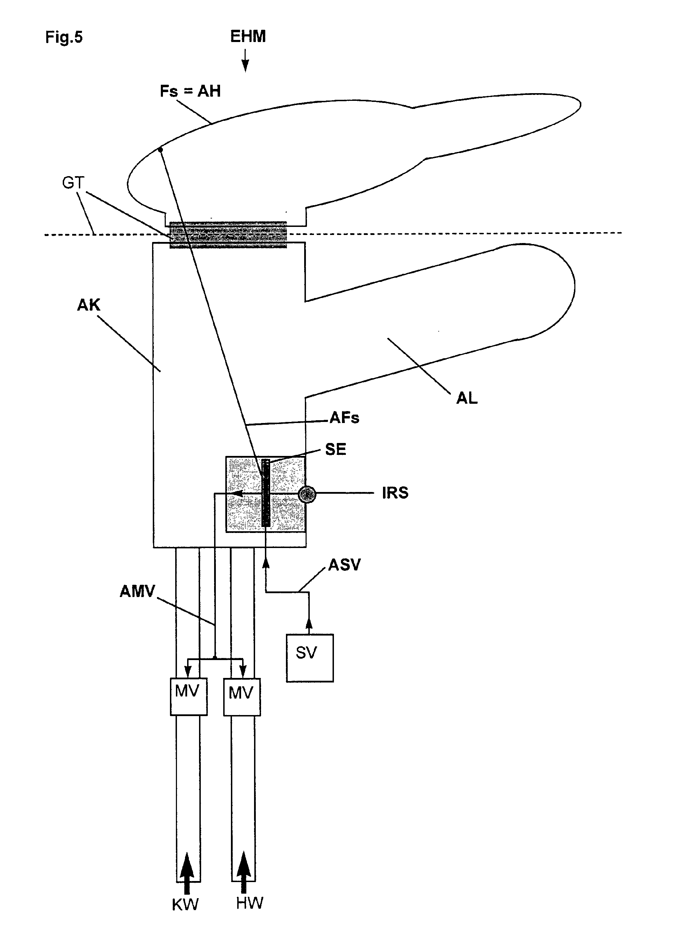

Fig. 5 zeigt eine erfindungsgemäße Sanitärarmatur EHM, in die der Berührungssensor S integriert ist, am Beispiel einer Einhandmischarmatur EHM mit einem Kaltwassereinlauf KW, einem Heißwassereinlauf, HW mit jeweils einem Magnetventil MV, einem Armaturgrundkörper AK, der mit einem Auslauf AL verbunden ist, und mit einem in der Zeichnung nicht dargestellten mechanischen Ventil, das beispielsweise als Eingriffmischventilkartusche ausgebildet ist, die über einen Handgriff AH betätigbar ist. Der Bedienhebel AH der Armatur EHM ist erfindungsgemäß über einen elektrischen Isolator GT von den übrigen Teilen der Armatur galvanisch getrennt und als Sensorfläche Fs des Berührungssensors S ausgebildet und über einen einzigen isolierten, aber nicht abgeschirmten Leiter AFs mit der Steuerungselektronik SE des Berührungssensors S verbunden, die innerhalb des Grundkörpers AK der Armatur angeordnet ist. Die Steuerungselektronik des Berührungssensors ist in bekannter Weise über eine Anschlußleitung AMV mit den Magnetventilen MV verbunden und über eine zweite Anschlußleitung ASV für die Stromversorgung mit einer Batterie SV verbunden, die geeigneterweise ebenfalls innerhalb des Grundkörpers AK der Armatur angeordnet ist. Die Batterie SV kann jedoch auch von der Armatur getrennt angeordnet sein, wobei in diesem Fall vorteilhaft ein in Fig. 4 dargestelltes Kopplungsglied KP, das aus dem Kondensator Ce1 und dem Widerstand Re1 besteht, zwischen den Minuspol der Batterie und das Armaturengehäuse AK geschaltet ist. Es ist klar, dass der Berührungssensor S auch mit einer Netzspannungsquelle mit Strom versorgt werden kann, was im Sanitärarmaturenbereich aus Sicherheitsgründen jedoch nicht wünschenswert ist.

Bei diesem Ausführungsbeispiel der vorliegenden Erfindung ist der gesamte Handgriff AH der Armatur als Sensorfläche Fs des Berührungssensors S ausgebildet, wobei die Steuerungselektronik SE des Berührungssensors S derart eingestellt ist, dass bei einer Berührung des Handgriffs an einer beliebigen Stelle mit der Hand oder einem Finger die beiden Magnetventile MV, geöffnet werden und gleichzeitig den Kaltwasser- und Warmwasserzulauf KW, HW, freigeben. Vorteilhafter Weise ist in die Armatur EHM außerdem eine Infrarotsensorik IRS integriert, die ebenfalls über eine Steuerungselektronik mit den Magnetventilen MV verbunden ist und derart angeordnet ist, daß von der Infrarotsensorik der Status einer Anwesenheitsdetektion, zum Beispiel einer Hand im Bereich des Wasserauslaufs, der Armatur ermittelt wird und mit der Infrarotsensorik ebenfalls in bekannter Weise die Magnetventile MV angesteuert werden. Mit der vorstehend beschriebenen erfindungsgemäßen Armatur EHM sind die folgenden Betriebszustände möglich.

1. Das mechanisch über den Handgriff AH betätigbare mechanische Ventil ist geschlossen, der Handgriff wird nicht berührt und die Infrarotsensorik IRS detektiert keine Anwesenheit eines Körperteiles oder eines Gegenstandes in der Nähe des Auslaufbereiches der Armatur. In diesem Betriebszustand sind die beiden Magnetventile MV ebenfalls geschlossen, mit dem Ergebnis, dass aus der Armatur kein Wasser austritt.

2. Der Handgriff AH des mechanischen Ventils wird an beliebiger Stelle mit der Hand berührt und/oder die Infrarotsensorik erkennt einen Gegenstand in der Nähe der Umgebung des Wasserauslaufs AL der Armatur, und das mechanische Ventil ist geschlossen. In diesem Betriebszustand erkennt die Steuerungselektronik des Berührungssensors S eine Berührung der Sensorfläche Fs und/oder die Steuerungselektronik der Infrarotsensorik erkennt die Anwesenheit eines Gegenstands oder Körperteils in der Nähe der Umgebung des Wasserauslaufs und die beiden Magnetventile MV werden geöffnet, mit dem Ergebnis, dass aus der Armatur kein Wasser austritt, da das mechanische Ventil geschlossen ist.

3. Das mechanisch über den Handgriff AH betätigbare Ventil ist geöffnet, die Sensorfläche Fs wird nicht berührt und die Infrarotsensorik erkennt keinen Gegenstand oder Körperteil in der Nähe oder Umgebung des Wasserauslaufs der Armatur. In diesem Betriebszustand ist das mechanische Ventil geöffnet und die beiden Magnetventile MV sind geschlossen, mit dem Ergebnis, dass kein Wasser aus der Armatur austritt.

4. Das mechanisch über den Handgriff AH betätigbare Ventil ist geöffnet und der Handgriff wird mit der Hand berührt und/oder die Infrarotsensorik erkennt einen Gegenstand oder ein Körperteil in der Nähe oder Umgebung des Wasserauslaufs AL der Armatur. In diesem Betriebszustand sind die beiden Magnetventile MV geöffnet, und das mechanische Ventil ist ebenfalls geöffnet, mit dem Ergebnis, dass Wasser aus der Armatur austritt.

Eine derartige mit einem erfindungsgemäßen Berührungssensor S versehene Sanitärarmatur EHM läßt sich daher besonders komfortabel bedienen. Eine Bedienperson ist in der Lage, mittels Berührung des Handgriffs AH des mechanischen Ventils die beiden Magnetventile MV zu öffnen, wobei erst bei Öffnung auch des mechanischen Ventils Wasser aus dem Auslauf der Armatur tritt. In diesem Betriebszustand ist es der Person gestattet, mit der zweiten Hand in den Wasserauslaufbereich zu greifen, um beispielsweise die Temperatur des Wassers zu prüfen, während die erste Hand durch Schwenken des Handgriffs die Wassertemperatur bedarfsgerecht einstellt. Bei Erreichen der gewünschten Wassertemperatur und auch der gewünschten Ausflußmenge, die ebenfalls über den Handgriff der Armatur einstellbar ist, läßt die Person den Handgriff los, wodurch die Sensorfläche Fs nicht mehr berührt ist. Solange die Bedienperson jedoch ein Körperteil oder einen Gegenstand in der Nähe oder Umgebung des Wasserausflusses hält und damit das heraustretende Wasser benutzt, wird dies von der Infrarotsensorik IRS erkannt, und die beiden Magnetventile MV bleiben daher geöffnet. Wenn die Bedienperson jedoch ihre Hände oder den Gegenstand aus dem Erfassungsbereich der Infrarotsensorik IRS entfernt, wird dies von der Infrarotsensorik IRS detektiert, und die beiden Magnetventile MV werden bei geöffnetem mechanischen Ventil geschlossen, so daß kein Wasser in die Armatur eintritt und dementsprechend auch kein Wasser aus der Armatur austritt. Hieraus ergibt sich der besondere Vorteil, dass eine einmal mit dem Handgriff des mechanischen Ventils eingestellte Wasserausflußmenge und Temperatur erhalten bleibt und nicht erneut eingestellt werden braucht, sondern durch einfaches Berühren des Handgriffs AH und/oder durch Einbringen von Gegenständen oder Körperteilen in die Nähe des Wasserauslaufs und damit in den Erfassungsbereich der Infrarotsensorik IRS die Magnetventile MV öffnet, und Wasser mit voreingestellter gespeicherter Temperatur und Austrittsmenge aus der Armatur austritt.

Die Anordnung des erfindungsgemäßen Berührungssensors S in einer Sanitärarmatur ist besonders vorteilhaft, da für die Bereitstellung einer Sanitärarmatur mit den vorstehend beschriebenen Betriebszuständen und daraus resultierenden Vorzügen zur Aktivierung von Steuerungsfunktionen zusätzliche mechanische Schaltelemente wie beispielsweise Piezotaster oder Schalter und hierfür erforderliche Ausbrüche, Abdichtungen usw. nicht notwendig sind, da der Armaturenkörper bzw. Teile des Armaturenkörpers selbst Signalgeber bzw. Sensorelement sind. Ein weiterer Vorteil der Anordnung eines erfindungsgemäßen Berührungssensors S in einer Sanitärarmatur ist, dass anders als bei herkömmlichen Berührungssensoren keine zusätzliche niederohmige unmittelbare Verbindung des Armaturenbasiskörpers mit dem Schutzleiterpotential (PE) erforderlich ist.

Die vorteilhafte Anordnung eines erfindungsgemäßen Berührungssensors S in einer Sanitärarmatur bei Ausbildung der Armatur oder eines Teiles der Armatur als mit der Sensorelektronik verbundene berührungssensitive Fläche ist in keiner Weise auf das vorstehend beschriebene Ausführungsbeispiel einer Einhandmischarmatur EHM beschränkt, und kann auf vielfältige Weise abgewandelt werden. So können beispielsweise Armaturen mit einer Vielzahl von berührungssensitiven, galvanisch isolierten Bereichen ausgebildet werden, die jeweils für sich eine berührungssensitive Fläche Fs eines Berührungssensors S zur Aktivierung und Deaktivierung von unterschiedlichen Funktionen, wie beispielsweise nur kaltes Wasser, nur warmes Wasser, Testmodus, Schlafmodus, Pausefunktion, Dauerlauf, Nachlauf usw. sein können. Mit dem erfindungsgemäßen Berührungssensor S lassen sich Armaturen mit mehr als einer bis hin mit zu einer Vielzahl von derartigen berührungssensitiven Flächen, deren Berührung unterschiedliche Funktionen auslöst, auf einfache Weise realisieren, wobei, da Teilbereiche der Armatur selbst als Sensor-Signalgeber fungieren, es möglich ist, diese optisch ansprechend auszubilden, ohne dass das Design der Armatur durch die Sensoren an der Armatur beeinträchtigt wird. Dabei kann die Oberfläche der Sensorfläche elektrisch leitend ausgebildet sein, aber auch elektrisch isoliert, z.B: lackiert ausgebildet sein, was die Funktionsfähigkeit des erfindungsgemäßen Berührungssensors S bei hinreichend dünn ausgebildeter Isolationsschicht nicht beeinträchtigt. Bei mit elektrisch isolierter Oberfläche ausgebildeter Sensorfläche Fs (z.B: lackierte Oberfläche) wird nämlich die durch deren Berührung verursachte Kapazitätsänderung von dem Sensor S detektiert.

Außerdem ist klar, daß der vorstehend am Beispiel eines Menschen beschriebene Berührungssensor S auch von einem Tier aktivierbar ist, das die Sensorfläche berührt.

Der erfindungsgemäße Berührungssensor S wird bei seinem erfindungsgemäßen Einsatz in Sanitärarmaturen in geeigneter Weise, wie vorstehend gesagt, mit einer Batterie mit Strom versorgt. Für den Betrieb des Berührungssensors S wird zwar im Verhältnis zu dem ebenfalls von der Batterie mit Strom versorgten Magnetventilen nur sehr wenig Strom verbraucht. Da es aber für den Betrieb der Armatur erforderlich ist, dass die Sensorelektronik SE eine Berührung der Sensorfläche FS im Dauerbetrieb abfragt, während die Magnetventile nur bei ihrer Öffnung/Schließung mit Energie versorgt zu werden brauchen, ist es für eine lange Lebensdauer der Batterie wünschenswert, den Stromverbrauch der Steuerelektronik des erfindungsgemäßen Berührungssensors S so gering wie möglich zu halten. Hierfür wird erfindungsgemäß eine mit dem Wechselspannungsgenerator der Steuerungselektronik gekoppelte Schaltvorrichtung zur alternierenden Aktivierung und Deaktivierung des Wechselspannungsgenerators bereitgestellt, deren Puls-Pausenverhältnis (Taktung) an die gewünschte tolerierbare Reaktionszeit angepaßt ist, die beispielsweise durch die maximale Frequenz einer aufeinanderfolgenden Berührung der Sensorfläche Fs mit dem Finger eines Menschen vorgegeben sein kann. Die Taktung ist geeigneterweise, vorgegeben auch durch den jeweiligen Einsatz der Armatur (z.B: in Haushalt, öffentlichen Bereichen, etc. ), entsprechend optimiert auf störungssicheren Betrieb (z.B: das Erkennen von Doppelberührungen) bei minimalem Energieverbrauch.

Für ein reibungsloses Funktionieren des Berührungssensors S kann beispielsweise die Steuerungselektronik über einen Zeitraum bis zu 1/10 Sekunde deaktiviert sein, auf den eine Aktivierungszeit der Steuerungselektronik von lediglich 1/100 Sekunde folgt. Hierdurch ist es vorteilhaft möglich, den Energiebedarf der Steuerungselektronik des erfindungsgemäßen Berührungssensors S um ein Vielfaches zu reduzieren und dadurch die Lebensdauer einer Batterie entsprechend zu verlängern.

**Patentansprüche**

1.  Berührungssensor (S) **gekennzeichnet durch**:

    eine gegenüber Erdpotential isolierte leitfähige Sensorfläche (Fs);
    die Sensorfläche (Fs) ist über einen Meßwiderstand (Rs) mit einem Wechselspannungsgenerator (U) verbunden; wobei
    die an dem Meßwiderstand (Rs) anliegende Spannungsdifferenz (Us) als Meßsignal dient.

2.  Berührungssensor (S) nach Anspruch 1 **gekennzeichnet durch**:

    ein erster Eingang ($\bar{A}$) einer AND-Schaltung ist generatorseitig über eine NOT-Schaltung mit dem Meßwiderstand (Rs) verbunden;
    ein zweiter Eingang (B) der AND-Schaltung ist sensorflächenseitig mit dem Meßwiderstand (Rs) verbunden;
    der AND-Schaltung ist ein Integrator (TP) nachgeschaltet;
    dem Integrator (TP) ist ein Komparator (C) und/oder Mikrokontroller (C) nachgeschaltet.

3.  Berührungssensor (S) nach Anspruch 2 **gekennzeichnet durch**:

    der Wechselspannungsgenerator (U) ist mittels einem
    ersten Gatter (GATTER 1) aufgebaut;
    die NOT-Schaltung ist mittels einem zweiten Gatter (GATTER 2) aufgebaut; die AND-Schaltung ist mittels einem dritten Gatter (GATTER 3) und einem vierten Gatter (GATTER 4) aufgebaut.

4.  Berührungssensor (S) nach Anspruch 2 und Anspruch 3 **gekennzeichnet durch**:
    zwischen das zweite (GATTER 2) und dritte Gatter (GATTER 3) ist ein NullSignal Kompensationsglied (KS) bestehend aus einem Tiefpaß (R2/C2) geschaltet.

5.  Berührungssensor (S) nach Anspruch3 oder 4 **gekennzeichnet durch**:
    dem vierten Gatter (GATTER 4) ist ein Integrator (TP) und ein Komparator (C) und/oder ein Mikrokontroller (C) nachgeschaltet.

6.  Sanitärarmatur (EHM), **gekennzeichnet durch**:
    wenigstens ein Berührungssensor (S) nach einem der Ansprüche 1 bis 5 ist in die Sanitärarmatur (EHM) integriert und dient zur Steuerung wenigstens eines Magnetventils (MV, MV) an einem Wasserzulauf (KW, HW) der Armatur.

7.  Armatur (EHM) nach Anspruch 6,
    **gekennzeichnet durch**:
    die Armatur (EHM) weist ein handbetätigbares Bedienelement (AH) zum Öffnen/Schließen eines mechanischen Ventils auf, das den Magnetventilen (MV) im Wasserzulauf der Armatur nachgeschaltet ist.

8.  Armatur (EHM) nach Anspruch 6 oder 7, **gekennzeichnet durch**:

    das Bedienelement (AH) der Armatur (EHM) dient als Sensorfläche (Fs) und ist über ein Anschlußkabel (AFs) mit der Steuerungselektronik (SE) des Sensors S verbunden;
    das Bedienelement (AH) ist galvanisch isoliert angeordnet.

9.  Armatur (EHM) nach einem der Ansprüche 6 bis 8, **gekennzeichnet durch**:
    in der Armatur sind mehrere Berührungssensoren (S) angeordnet, die jeweils mit verschiedenen galvanisch isoliert ausgebildeten Elementen der Armatur (EHM) oder deren Teilstücke verbunden sind.

**10.** Armatur (EHM) nach einem der Ansprüche 6 bis 9, **gekennzeichnet durch**:
neben dem Berührungssensor (S) ist in der Armatur (EHM) außerdem eine Infrarotreflexlichtschranke mit Steuerelektronik (IRS) zur Betätigung der elektronisch steuerbaren Ventile (MV) angeordnet.

**11.** Armatur (EHM) nach einem der Ansprüche 6 bis 10, gekennzeichnet, durch:
die in der Armatur (EHM) angeordnete Sensorelektronik wird von einer Batterie mit Energie versorgt.

**12.** Armatur (EHM) nach Anspruch 11, gekennzeichnet, durch:
die Batterie ist innerhalb der Armatur (EHM) angeordnet.

**13.** Armatur (EHM) nach Anspruch 11, gekennzeichnet, durch:
der Minuspol der Batterie ist über ein Koppelglied (KP) mit der Armatur (EHM) verbunden.

**14.** Verfahren zur Erkennung der Berührung einer elektrisch leitenden Oberfläche **gekennzeichnet durch**:

es wird ein Berührungssensor (S) nach einem der vorstehenden Ansprüche 1 - 13 verwendet;
der komplexe Leitwert eines menschlichen Körpers (M) wird erkannt;
die Berührungserkennung erfolgt durch Messung und Auswertung eines Stromflusses ($\underline{Ia}$) in Richtung aus dem Sensor (S) zur Person (M), die die Sensorfläche (Fs) berührt und/oder in Richtung von der Person (M) in den Sensor.

**15.** Verfahren zur Erkennung der Berührung einer elektrisch leitenden Oberfläche, **gekennzeichnet durch**:
die Spannungsdifferenz an einem Meßwiderstand (Rs) wird durch eine Signalverarbeitungselektronik bestehend aus Differenzverstärker (NOT, AND), Integrator (TP), und Komparator (C) und/oder Mikrokontroller (C) ausgewertet, wobei die durch die Berührung der Sensorfläche (Fs) erzeugte Phasenverschiebung der an dem Meßwiderstand (Rs) anliegenden Spannung ($\underline{Us}$) gemessen wird.

**16.** Verfahren zur Erkennung der Berührung einer elektrisch leitenden Oberfläche, nach Anspruch 15 **gekennzeichnet durch**:
es wird ein Berührungssensor (S) nach einem der Ansprüche 1 bis 13 verwendet.

Fig.1

**Fig.2**

$$\underline{U}Rs = A - B$$

$$A = Uo$$

$$B = Ua$$

$$\underline{U}Rs = Uo - Ua$$

$$\underline{U}Rs = Rs * \underline{I}a$$

$$Us\left| = \frac{Rs}{Rs + (Rm + 1/jwCm)} \cdot Uo \right.$$

$$\left| S1 = ON \right.$$

Fig.3

# Fig. 4

EP 1 134 895 A2

**Fig.5**